# EUROPEAN PATENT APPLICATION

(11) **EP 0 769 788 A2**
(43) Date of publication of application: **23.04.1997**
(21) Application number: 96307535.3
(22) Date of filing: 17.10.1996
(51) Int. Cl.: H01B 3/44

(54) **Low dielectric constant material for use as an insulation element in an electronic device**

(30) Priority: 11.01.1996 US 584848; 20.10.1995 US 5759
(71) Applicant: W.L. GORE & ASSOCIATES, INC., Newark, Delaware 19714-9206 (US)
(72) Inventor: Rosenmayer, Thomas C., Eau Claire, Wisconsin 54701-5632 (US)
(74) Representative: McCallum, William Potter

(57) **Abstract**

A low dielectric constant material is provided for use as an insulation element in an electronic device, such as but not limited to an integrated circuit structure for example. Such a low dielectric constant material may be formed from an aqueous fluoropolymer microemulsion or microdispersion. The low dielectric constant material may be made porous, further lowering its dielectric constant. The low dielectric constant material may be deposited by a spin-coating process and patterned using reactive ion etching or other suitable techniques.

## Description

The present invention generally relates to high speed integrated circuits. More particularly, the present invention relates to an improved dielectric material for use as an insulation element in an electronic device, such as but not limited to an integrated circuit structure.

Future high performance integrated circuits will require interlayer dielectric (ILD) materials with as low a dielectric constant as possible. One conventional method of forming an ILD is to deposit a layer of silicon dioxide (SiO₂₎ using chemical vapor deposition (CVD) techniques. Such an ILD provides a conformal layer over the metal signal traces of an integrated circuit. Following the CVD of the SiO₂, a layer of planarizing glass is applied, typically using a spin-on deposition technique. The planarizing glass is then polished flat using a process known as chemical mechanical polishing. These glass layers must be carefully deposited so as to reduce the amount of residual mechanical stress. Because of the high elastic modulus of the glass, an incorrect amount of residual stress can cause severe reliability problems in the metal signal traces.

A description of the effects of stresses on the reliability of integrated circuits is given, for example, by C.T. Rosenmayer, et al., in, "EFFECT OF STRESSES ON ELECTROMIGRATION", *29th Annual Proceedings of the IEEE International Reliability Physics Symposium, 1991.*

Several materials have been proposed for use as a low dielectric constant ILD. These materials include porous glass; fluorinated glass; a material comprising a copolymer of 2,2-bistrifluoromethyl-4,5-difluoro-1,3-dioxole (PDD) with tetrafluoroethylene (TFE); fluorinated polyimides; and fluorinated poly (benzocyclobutens). Although these materials may operate with varying degrees of success in certain applications, they suffer from a multiplicity of shortcomings which have detracted from their usefulness. For example, these materials vary in reliability, and have long process cycles, inadequate thermal and chemical stability, and high stress. Additionally, of these listed materials, only porous glass and PDD-TFE copolymers have a dielectric constant of less than 2.2. However, porous glass is limited in practicality by its long processing time (∼10 hours), while PDD-TFE copolymer has insufficient thermal stability.

The foregoing illustrates limitations known to exist in present integrated circuit structures. It is apparent that it would be advantageous to provide an improved low dielectric constant material, for use as an insulation element in an integrated circuit structure, directed to overcoming one or more of the limitations set forth above. Accordingly, a suitable alternative is provided which has a minimal dielectric constant, has thermal stability above 400°C, and possesses reasonable processing times.

According to the present invention there is provided an improved electronic device, the improvement comprising a fluoropolymer or a fluorinated polymer dielectric element, said element having a weight loss of less then 0.15%/minute at 420°C, and a thickness of less than 5µm.

According to a further aspect of the present invention there is provided an improved dielectric material for use as an insulation element in an integrated circuit structure, the improved dielectric material comprising a fluoropolymer material or a fluorinated polymer material having a weight loss of less than 0.15%/minute at 420°C and a thickness of less than 5µm.

The present invention provides a low dielectric constant material for use as an insulation element in an electronic device, such as but not limited to an integrated circuit structure for example. Such a low dielectric constant material may be formed from an aqueous fluoropolymer microemulsion or microdispersion. The low dielectric constant material may be made porous, further lowering its dielectric constant. The low dielectric constant material may be deposited by a spin-coating process and patterned using reactive ion etching or other suitable techniques.

In one embodiment of the present invention, an improved electronic device is provided wherein the improvement comprises a fluoropolymer dielectric material having a dielectric constant of less than 2.2, a weight loss of less than 0.15%/minute at 420°C, and a thickness of less than 5µm.

The aqueous fluoropolymer microemulsion or microdispersion is prepared with very small cells of monomer molecules dispersed throughout an aqueous medium. The small cells each act as a polymerization site to form very small particles of polymers. The microemulsion is polymerized to produce a colloidal polymerization system containing a fluoropolymer, such as polytetrafluoroethylene (PTFE), or its copolymers. The particles have an average diameter ranging from 1 to about 80 nanometers.

In one embodiment of the present invention, the ratio of surfactant to TFE monomer necessary to produce small particles has been found to be 1.17 or more. The colloidal polymer particles may contain 20 to 100% by weight of polymerized tetrafluoroethylene and form 0 to 80% by weight of units of at least one monomer copolymerizable with tetrafluoroethylene. The co-monomers include fluorine-containing olefins of 2-18 carbons, chlorine-containing olefins of 2-18 carbons, or fully hydrogenated olefins of 2-18 carbons for example ethylene or propylene. Crosslinking agents may be present, for example, glycidylvinyl ether, chloroalkyl vinyl ether, and the like.

It has been found that different forms of polytetrafluoroethylene can be obtained depending on the ratio of components in the microemulsion. More particularly, when the ratio of surfactant to liquid TFE monomer is about 1:1, the PTFE material found is platelet-like. When the ratio of surfactant to liquid TFE monomer is greater than 1.17, small particles of PTFE are formed. Thus, ratios of surfactant to TFE monomer, by weight, of over 1.17 are beneficial in producing small, round particles of PTFE of very high molecular weight.

Embodiments of the present invention will now be described, by way of example, with reference to the accompanying drawings in which:-
Figure 1 is an scanning electron micrograph (SEM) cross-section of a 0.75 micron PTFE film in accordance with the teachings of the present invention;
Figure 2 is an SEM surface view of a single crystal silicon wafer which has been coated with a bicontinuous PTFE microemulsion in accordance with the teachings of the present invention; and
Figure 3 is a graph of Deposited Film Thickness (Angstroms) v. Spin Speed (RPM) in accordance with the teachings of the present invention.
Figure 4 is a graph of Isothermal Weight Loss Rate (%/minute) v. Temperature.

The present invention comprises a low dielectric constant material for use as an insulation element in an electronic device, such as an integrated circuit structure. The integrated circuit structure, which may be an active or passive device, may contain one or more interlayer dielectric (ILD) layers of the low dielectric constant material of the present invention, which is formed from a fluoropolymer microemulsion or microdispersion.

As used herein, a microemulsion or microdispersion means a stable isotropic mixture of resin, oil, water, and/or surfactant which forms spontaneously upon contact of the ingredients. Other components, such as salt or a co-surfactant (such as an alcohol, amine, or other amphiphilic molecule) may also be part of the microemulsion formulation. The oil and water reside in distinct domains separated by an interfacial layer rich in surfactant. Because the domains of oil or water are so small, microemulsions appear visually transparent or translucent. Unlike emulsions, microemulsions are equilibrium phases.

Microemulsions can have several microstructures, depending upon composition, and sometimes upon temperature and pressure. There are three most common structures. One is an oil-in-water microemulsion where oil is contained inside distinct domains (droplets) in a continuous water-rich domain. The second is water-in-oil microemulsion, so-called inverse microemulsions, where water is contained inside distinct domains (droplets) in a continuous oil-rich domain. The third is a bicontinuous microemulsion where there are sample-spanning intertwined paths of both oil and water, separated from each other by a surfactant-rich sponge-like structure.

Polymerization of emulsified and microemulsified unsaturated hydrocarbon monomers is known, where high reaction rates, high conversions and high molecular weights can be achieved. A microemulsion can be distinguished from a conventional emulsion by its optical clarity, low viscosity, small domain size, thermodynamic stability and spontaneous formation. Polymerization of microemulsified monomers has many advantages over traditional polymerization of emulsified monomers. Microemulsions are normally transparent to translucent so that they are particularly suitable for photochemical reactions, while emulsions are turbid and opaque. Also, the structural diversity of microemulsions (droplets and bicontinuous) is set by thermodynamics, and rapid polymerization may be able to capture some of the original structure. In addition, microemulsion polymerization enables the production of stable, monodisperse microlatexes containing colloidal particles smaller than those produced from classical emulsion polymerization processes. Smaller particle size improves the ability to form coatings without microcracking. The increased surface area improves particle fusion during molding operations.

Emulsion polymerization, as opposed to microemulsion polymerization, of dissolved gaseous tetrafluoroethylene (PTFE) or its copolymers is a known process. Aqueous colloidal dispersions of PTFE or its copolymers can be prepared in a pressure reactor by placing the gaseous monomer, or a mixture of monomers in contact with an aqueous solution containing at least one emulsifier which generally is a fluorinated surfactant, possibly a buffer for keeping the medium at a given pH, and at least an initiator which is capable of forming free radicals at the polymerization temperature. The free radical initiators can be water soluble peroxides, or alkaline or ammonium persulfates. Persulfate can be used alone if the polymerization temperature is above approximately 50°C, or in association with a reducing agent such as ferrous salt, silver nitrate, or sodium bisulfite if the polymerization temperature is approximately between 5 to 55°C, as described in the U.S. Patent No. 4,384,092, which is incorporated herein by reference.

The gaseous monomer molecules in the foregoing process enter the aqueous liquid and react to form polymer without first forming a distinct liquid phase. Thus, the polymer particles are large particles suspended in the aqueous mixture; and the process is not a true liquid-in-liquid emulsion polymerization. The process is sometimes referred to as dispersion polymerization.

Microemulsion polymerization operates by a different mechanism than emulsion polymerization. It involves polymerization of liquid monomer rather than gaseous monomers. Because the polymerization involves polymerization of unusually small cells of liquid monomer, the resulting polymer particles are unusually small. However, polymerization of liquid TFE is not usually practiced because of the well known potential handling hazards.

As the term is used herein "low dielectric constant" means a dielectric constant of between about 1.0 and 3.0, whereas a conventional SiO₂ ILD material has a dielectric constant of 3.9.

By having a dielectric constant of between 1.0 and 3.0, an ILD formed by the teachings of the present invention forms an electrically insulating layer between two electrically conducting layers, such as polysilicon or metal, which is effective in lowering the effective capacitance, reducing the crosstalk, and increasing the signal velocity of propagation (VP) of the conductive layers separated by the ILD.

As the term is used herein "fluoropolymer" means a polymer with a fully fluorinated structure. In a fully fluorinated polymer, essentially all of the hydrogen atoms are replaced by fluorine atoms.

As the term is used herein "fluorinated polymer" means a polymer with a partially fluorinated structure. In a partially fluorinated structure not all of the hydrogen atom are replaced by fluorine atoms.

The thickness of an ILD formed in accordance with the teachings herein is in a range of from about 0.1 to about 5.0 µm. More typically, the thickness is in a range of from about 0.5 to about 1.5 µm. Such a range of thicknesses may be particularly desired for producing present and future generation integrated circuit structures.

The low dielectric material of the present invention is a fluoropolymer which is deposited from a microemulsion or microdispersion comprising particles of approximately an average size of from about 1 to about 80 nanometers (0.001 to 0.080 micrometers), preferably from about 1 to about 60 nanometers, and most preferably from about 1 to about 30 nanometers; surfactant; and water. The fluoropolymer may include, but is not limited to, polytetrafluoroethylene (PTFE), fluorinated ethylenepropylene (FEP), fluoromethacrylate (Fac), or perfluoroalkoxy polymer (PFA).

The low dielectric material may have porosity induced in order to reduce its dielectric constant. The porosity may be created by employing a bicontinuous microemulsion. Such a bicontinuous fluoropolymer microemulsion system contains both oil (monomer) phase and aqueous phase intertwined into each other, separated by surfactant layers. A rapid polymerization of the monomers (oil phase) can capture the unpolymerized microstructure. When the water is removed during the drying step, a porous structure is left behind.

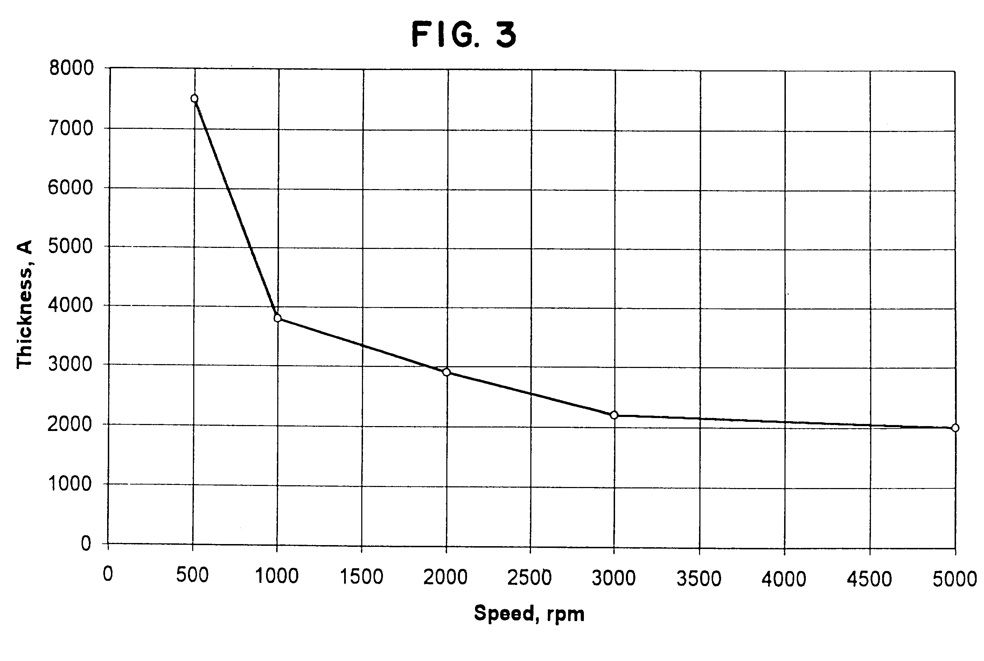

The low dielectric constant material of the present invention may be deposited to form an ILD by a spin coating process using a microemulsion liquid. The spin coating process is comprised of several steps which are outlined hereinafter:
1) A substrate, such as a silicone wafer for example, is spun at about 500 RPM. While the substrate is spinning at such a speed, a wetting agent, such as isopropanol, is dispensed onto the surface of the spinning substrate to wet out the surface of the substrate.
2) A fluoropolymer microemulsion is dispensed onto the surface of the spinning substrate, while it is spinning at 500 rpm.
3) The rotational speed of the substrate is next increased to a range of from about 1000 to about 5000 RPM. The rotational speed employed determines the thickness of the dielectric layer achieved, as best seen by reference to Figure 3.
4) The increased rotational speed is maintained, until the coating thickness of the microemulsion stabilizes. Typically, stabilization occurs in from 10 to about 50 seconds, depending on the rotational speed. In this regard, a faster speed requires less time to stabilize.
5) The coated substrate is initially baked at a temperature of about 200°C to drive off the water and surfactant of the microemulsion.
6) Thereafter, the substrate is baked at near the melting point of the fluoropolymer in order to improve its adhesion to the substrate.
7) The substrate is slowly cooled to about 200 °C by raising it above the surface of a heating device, such as a hot plate for example.
8) Finally, the substrate is cooled to an ambient temperature condition by using a chill plate.

If desired, the substrate may be planarized, imaged, and/or etched by employing conventional integrated circuit processing techniques which are known to those skilled in the art.

### MICROEMULSION POLYMERIZATION PROCEDURE FOR PRODUCING SMALL PARTICLES OF POLYTETRAFLUOROETHYLENE

An aqueous microemulsion polymerization procedure produces unusually small particles of polytetrafluoroethylene (PTFE) which is particularly useful to form a low dielectric constant ILD in accordance with the teachings herein.

The ingredients, ratios and conditions of the microemulsion are selected to result in polymerization of liquid tetrafluoroethylene (TFE). In one aspect, the resulting polymers have a three-dimensional continuous micro-network of fibrils and bundles of fibrils and randomly dispersed platelets of TFE polymers. In another aspect, the resulting polymer produced is a gel characterized as a spongy mass comprised visually of layers of sheet-like configurations, and which has a microstructure of a three-dimensional continuous network of convoluted randomly disposed fibrils and bundles of fibrils of TFE polymers. In another aspect, the polymer produced is characterized as a spongy mass having a microstructure of predominantly randomly disposed platelets interconnecting or interpenetrating one another and also being randomly connected by randomly disposed fibrils, to form a three-dimensional continuous network of TFE polymer. In still another aspect, very small particles of TFE polymer are produced. Which form of polymer is produced depends on the ratio of surfactant to liquid TFE, as described above.

By microstructure, and the like, it is meant that the structure is not visible to the naked eye.

To form the polymers, a mixture of liquid tetrafluoroethylene (TFE) and at least one fluorinated surfactant in water is employed. The TFE may be introduced to the reaction vessel in liquid form, or in gaseous form and subsequently liquefied, in the presence of microemulsified seed particles, or micelles, of a liquid perfluorinated hydrocarbon that is a saturated aliphatic or aromatic organic compound having up to 2 oxygen, nitrogen, or sulfur atoms and a molecular weight preferably below 500.

PTFE produced from microemulsion polymerization when the surfactant/monomer ratio is at least 1.17 are usually small, being on the order of an average size of from 1 to 80 nanometers (0.001 to 0.080 micrometers), preferably 1 to 60 nanometers and most preferably 1 to 30 nanometers, and a polymer average molecular weight of over 100,000, preferably over 500,000 and most preferably over 1,000,000. It is believed that such unusually small polymer particles are obtained because polymerization of the gaseous TFE takes place inside the very small micelles of the hydrocarbon organic compound in the microemulsion.

The amount of surfactant used in the reaction is adjusted to maximize the formation of the type of particle desired, as described above. A suitable fluorinated surfactant or a mixture of fluorinated surfactants are needed with the weight ratio of the surfactants to monomers in the liquid phase of being adjusted according to the product desired. There is no criticality in an upper limit, but generally one usually does not go higher than 5:1. Suitable fluorinated surfactants include a fluorinated anionic surfactant, for example a salt of a fluorinated carboxylic acid or a sulfonic acid, a sulfate, a cationic surfactant for example a fluorinated quartenary ammonium salt; or a fluorinated nonionic surfactant. The mixture can be formed preferably at a temperature below the critical temperature (Tc) of TFE, approximately 33.3°C for TFE, and above the freezing temperature of the surfactant containing aqueous solution. Mechanical stirring can be provided. Free radical polymerization can be initiated by adding water-soluble free radical initiators, for example, a peroxide, an alkaline or ammonium persulfate, or some water soluble azo compounds or a salt of permanaganate. The free radical initiators can also be used in association with a reducing agent such as ferrous salt, silver nitrate, sodium bisulfite, and the like. It is also possible to initiate the polymerization by photochemical reactions. The possible photoradiation source include ultraviolet (UV) light, electron beam, or gamma radiation. The polymerization temperature can be between 5 to 100°C, and preferably between 5 to 33.3°C for polytetrafluoroethylene.

Comonomers that may be present in the mixture include halogenated (chlorine or fluorine) olefins of 2-18 carbon atoms, for example vinyl chloride, vinylidene chloride, chlorotrifluoroethylene, hexafluoropropylene, perfluoroalkyl vinyl ether, or the like; hydrogenated unsaturated monomers, such as ethylene, propylene, isobutylene, vinyl acetate, acrylates, or the like; crosslinking agents, such as glycidylvinylether, chloroalkyl vinyl ether, allyl-glycidylether, acrylates, methacrylates, or the like. The amount of comonomer that can be present should not be so great as to change the nature of the product that would be obtained if PTFE had been the product.

The perfluorinated hydrocarbon is a low molecular weight compound that is liquid at the temperature at which polymerization is carried out. The molecular weight is preferably less than 500. The perfluorinated hydrocarbon preferably has a boiling point less than 230°C. The perfluorinated hydrocarbon can be a perfluorinated saturated aliphatic compound such as a perfluorinated alkane; a perfluorinated aromatic compound such as perfluorinated benzene, or perfluorinated tetradecahydro phenanthene. It can also be a perfluorinated alkyl amine such as a perfluorinated trialkyl amine. It can also be a perfluorinated cyclic aliphatic, such as decalin; and preferably a heterocyclic aliphatic compound containing oxygen or sulfur in the ring, such as perfluoro-2-butyl tetrahydrofuran.

Examples of perfluorinated hydrocarbons include perfluoro-2-butyltetrahydrofuran, perfluorodecalin, perfluoromethyldecalin, perfluorodimethyldecalin, perfluoromethylcyclohexane, perfluoro(1,3-dimethylcyclohexane), perfluorodimethyldecahydronaphthalene, perfluorofluoorene, perfluoro(tetradecahydrophenanthrene), perfluorotetracosane, perfluorokerosenes, octafluoronaphthalene, oligomers of poly(chlorotrifluoroethylene), perfluoro(trialkylamine) such as perfluoro(tripropylamine), perfluoro(tributylamine), or perfluoro(tripentylamine), and octafluorotoluene, hexafluorobenzene, and commercial fluorinated solvents, such as Fluorinert FC-75 which is produced by the 3M Company. The fluorinated alkanes can be linear or branched, with a carbon atom number between 3 and 20. Oxygen, nitrogen or sulfur atoms can be present in the molecules, but the number of such atoms per molecule should be 2 or less.

The preparation of the microemulsion depends on careful selection of the ingredients. The microemulsion is prepared by mixing water, perfluorinated hydrocarbon, fluorinated surfactant(s), and optionally cosolvents or inorganic salts. The amounts employed are 0.1-40 weight percent, preferably 0.1-20, of the perfluorinated hydrocarbon; 0.1-40 weight percent, preferably 0.1-25, of the surfactant; and optionally cosurfactants; with the remainder water. The microemulsified perfluorinated hydrocarbons are believed to serve as microreactors for fluorinated monomers to enter and to be polymerized. The temperature of the microemulsion formation can be between 0 to 150°C, preferably 40 to 100°C.

The fluorinated surfactant has the structure R_{f} E X, where R_{f} is a fluorinated alkyl group with a carbon number between 4 and 16, E is an alkylene group with a carbon number between 0 and 4, and X is an anionic salt such as COOM, SO₃M, SO₃NR₂, SO₄M, a cationic moiety such as quarternary ammonium salt, or an amphoteric moiety such as aminoxide, or a non-ionic moiety such as (CH₂CH₂O)ₙH; and M is H, Li, Na, K, or NH₄; R is a 1 to 5C alkyl group and n is a cardinal number of 2 to 40.

When tetrafluoroethylene is referred to herein, it is understood the term includes the so-called modified "homopolymer", in which the polymer chain includes very small amounts of units derived from perfluorol(propyl vinyl ether) or hexafluoropropylene.

To initiate polymerization, the temperature of the microemulsion is adjusted to between 0 and 150°C, preferably 40 to 100°C. Initiators for polymerization include free-radical initiators, such as persulfates, azo initiators, peroxides, or photo initiators which can generate free radicals by ultraviolet or gamma rays. Amount of initiators present can range between 0.001 to 5 percent by weight based on the final polymer content. Cosolvents such as an alcohol, amines or other amphiphilic molecules, or salt can be employed if desired to facilitate formation of the microemulsion.

Tetrafluoroethylene is introduced to the reactor from the vapor phase into the aqueous microemulsion phase. Sufficient mixing between liquid and vapor phase is important to encourage mass transfer. The mechanism of forming the ultra small polymer particles is not fully understood. It is believed that the higher the solubility of the tetrafluoroethylene monomer in the perfluorinated hydrocarbon, the better to achieve the original microemulsion particle size and shape. The time of reaction may be between 1 and 500 minutes.

The resulting polymer particles in the resulting dispersion have an average particle size of between 1 and 80 nanometers, preferably 1 to 60, most preferably 1 to 30, and a polymer average molecular weight of over 100,000, preferably over 1,000,000. The unusually small particle size provides a polymer system with a number of advantages over systems containing larger particles. The system is an aqueous colloidal dispersion, and is clear rather than turbid.

A small amount of units from comonomers may be present in the polymer, provided the amount of comonomer that can be present is not so great as to change the nature of the product that would be obtained if PTFE had been the product. In other words, the copolymer is still not melt processible. The comonomer can be a halogenated (chlorine or fluorine) olefin of 2-18 carbon atoms, for example vinyl chloride, vinylidene chloride, chlorotrifluoroethylene, hexafluoropropylene, perfluoroalkyl vinyl ether, or the like; hydrogenated unsaturated monomers, such as ethylene, propylene, isobutylene, vinyl acetate, acrylates, or the like; crosslinking agents, such as glycidylvinylether, chloroalkyl vinyl ether, allyl-glycidylether, acrylates, methacrylates, or the like.

One suitable microemulsion for use as an ILD in accordance with the teachings here had a weight ratio of surfactant to TFE liquid monomer of 330/230, i.e., well over 1.17. The resulting polymer was comprised of very small particles of PTFE, on the order of from about 0.001 to 0.06 micrometer. Such a material may be made by initially charging into a 10 liter pressure vessel, 5 Kg of deionized H₂0 and 330g of ammonium perfluoroctanoate (Fluorad FC143, 3M). The pressure vessel was under vacuum and had been purged with tetrafluoroethylene gas by a vacuum repressive sequence three times. The oxygen content of the aqueous mixture was less than 20 ppm. The pressure vessel was cooled to be about 10°C and tetrafluoroethylene gas was fed into the reactor and some tetrafluoroethylene was allowed to condense into a liquid form in aqueous phase. Total amount of liquid tetrafluoroethylene .charged to the pressure vessel was about 230g. The APFO/TFE ratio was over 1.17. The pressure vessel was equipped with a mixer and was used to stir the aqueous mixture at a speed of about 400 rpm. 2 grams of ammonium persulfate in 100g H₂0 were charged to the vessel, followed by 1 gram of ferrous sulfate (FeS0₄) and 2 grams of sodium sulfite (Na₂S0₃) in 100g H₂0 to initiate polymerization. The pressure inside the vessel was about 30 Kg/cm² starting from initiation to the end of about 2 hours reaction time. There was no significant pressure change throughout the reaction, which indicated that very little tetrafluoroethylene in the vapor phase participated the reaction. The temperature of the aqueous mixture inside the vessel was maintained between 10-12°C, employing brine water. After about 2 hours of reaction, tetrafluoroethylene gas was released from the vessel and the aqueous dispersion was discharged.

The aqueous dispersion looked clear, and contained about 4% polymer content. The melting temperature of the polymer was determined by Differential scan Calorimetry (DSC) to be about 331°C, which is in the melting range of polytetrafluoroethylene. The clarity of the dispersion is indicative of the presence of small particles on the order of 0.06 micrometer or less in size.

An ILD formed by a microemulsion of PTFE will have a dielectric constant of between 1.0 and 3.0.

### MICROEMULSION POLYMERIZATION PROCEDURE FOR PRODUCING SMALL PARTICLES OF MELT PROCESSIBLE FLUOROPOLYMER PARTICLES

An aqueous microemulsion polymerization procedure produces unusually small particles of melt-processible fluoropolymers. During this procedure, the polymerization is carried out in the presence of microemulsified seed particles, or micelles, of a liquid perfluorinated hydrocarbon that is a saturated aliphatic or aromatic organic compound having up to two oxygen, nitrogens, or sulfur atoms and a molecular weight preferably below 500.

The polymer particles so produced are usually small, being on the order of one average size of 1 to 80 nanometers (0.001 to 0.080 micrometers), preferably 1 to 60 nanometers, and most preferably 1 to 30 nanometers. It is believed that such unusually small polymer particles are obtained because polymerization takes place inside the very small micelles of the hydrocarbon organic compound in the microemulsion.

The perfluorinated hydrocarbon is a low molecular weight compound that is liquid at the temperature at which polymerization is carried out. The molecular weight is preferably less than 500. The perfluorinated hydrocarbon preferably has a boiling point less than 230°C. The perfluorinated hydrocarbon can be a perfluorinated saturated aliphatic compound such as a perfluorinated alkane; a perfluorinated aromatic compound such as perfluorinated benzene, or perfluorinated tetradecahydro phenanthene. It can also be a perfluorinated alkyl amine such as a perfluorinated trialkyl amine. It can also be a perfluorinated cyclic aliphatic, such as decalin; and preferably a heterocyclic aliphatic compound containing oxygen or sulfur in the ring, such as perfluoro-2-butyl tetrahydrofuran.

Examples of perfluorinated hydrocarbons include perfluoro-2-butyltetrahydrofuran, perfluorodecalin, perfluoromethyldecalin, perfluorodimethyldecalin, perfluoromethylcyclohexane, perfluoro(1,3-dimethylcyclohexane), perfluorodimethyldecahydronaphthalene, perfluorofluoorene, perfluoro(tetradecahydrophenanthrene), perfluorotetracosane, perfluorokerosenes, octafluoronaphthalene, oligomers of poly(chlorotrifluoroethylene), perfluoro(trialkylamine) such as perfluoro(tripropylamine), perfluoro(tributylamine), or perfluoro(tripentylamine), and octafluorotoluene, hexafluorobenzene, and commercial fluorinated solvents, such as Fluorinert FC-75 which is produced by the 3M Company. The fluorinated alkanes can be linear or branched, with a carbon atom number between 3 and 20. Oxygen, nitrogen or sulfur atoms can be present in the molecules, but the number of such atoms per molecule should be two or less.

The preparation of the microemulsion depends on careful selection of the ingredients. The microemulsion is prepared by mixing water, perfluorinated hydrocarbon, fluorinated surfactant(s), and optionally cosolvents or inorganic salts. The amounts employed are 0.1-40 weight percent, preferably 0.1-20, of the perfluorinated hydrocarbon; 1-40 weight percent, preferably 0.1-25, of the surfactant; and optionally cosurfactants; with the remainder water. The microemulsified perfluorinated hydrocarbons are believed to serve as microreactors for fluorinated monomers to enter and to be polymerized. The temperature of the microemulsion formation can be between 0 to 150°C, preferably 40 to 100°C.

The fluorinated surfactant has the structure R_{f} E X, where R_{f} is a fluorinated alkyl group with a carbon number between 4 and 16, E is an alkylene group with a carbon number between 0 and 4, and X is an anionic salt such as COOM, SO₃M, SO₃NR₂, SO₄M, a cationic moiety such as quarternary ammonium salt, or an amphoteric moiety such as aminoxide, or a non-ionic moiety such as (CH₂CH₂O)ₙH; and M is H, Li, Na, K, or NH₄; R is a 1 to 5C alkyl group and n is a cardinal number of 2 to 40.

The polymerizable fluorinated monomers that are other than tetrafluoroethylene, include hexafluoroethylene, perfluoro alkyl vinyl ether, trifluoroethylene, vinylidene fluoride, vinyl fluoride, chlorotrifluoroethylene. Nonfluorinated monomers can be used as comonomers, such as vinylidene chloride, vinyl chloride, ethylene, propylene, butadiene. The monomer is preferably free-radical polymerizable, and preferably is ethylenically unsaturated.

To initiate polymerization, the temperature of the microemulsion is adjusted to between 0 and 150°C, preferably 40 to 100°C. Initiators for polymerization include free-radical initiators, such as persulfates, azo initiators, peroxides, or photo initiators which can generate free radicals by ultraviolet or gamma rays. Amount of initiators present can range between 0.001 to 5 percent by weight based on the final polymer content. Cosolvents such as an alcohol, amines or other amphiphilic molecules, or salt can be employed if desired to facilitate formation of the microemulsion.

The fluorinated gaseous monomers are introduced to the reactor from the vapor phase into the aqueous microemulsion phase. Sufficient mixing between liquid and vapor phase is important to encourage mass transfer. The mechanism of forming the ultra small fluorinated melt-processible polymer particles in this invention is not fully understood. It is believed that the higher the solubility of the monomers in the perfluorinated hydrocarbon, the better to achieve the original microemulsion particle size and shape. The time of reaction may be between 1 and 500 minutes.

The resulting polymer particles in the resulting dispersion have an average particle size of between 1 and 80 nanometers, preferably 1 to 60, most preferably 1 to 30, and a polymer average molecular weight of over 100,000, preferably over 1,000,000. The unusually small particle size provides a polymer system with a number of advantages over systems containing larger particles. The system is an aqueous colloidal dispersion and is clear rather than turbid.

### BICONTINUOUS MICROEMULSION POLYMERIZATION PROCEDURE FOR PRODUCING SMALL PARTICLES OF POLYTETRAFLUOROETHYLENE

One method of polymerizing liquid tetrafluoroethylene in an aqueous dispersion is described below and in U.S. Patents 5,399,640 and 5,403,900, which are incorporated herein by reference.

The ingredients, ratios and conditions are selected to result in polymerization of liquid tetrafluoroethylene (TFE) and optionally, minor amounts of other fluorinated ethylenically-unsaturated monomers that can be present. Free radical polymerization of the monomers produces polymers of tetrafluoroethylene. The polymers have a three-dimensional continuous micro-network of fibrils and bundles of fibrils and randomly dispersed platelets.

The polymer produced is a gel characterized as a spongy mass comprised visually of layers of sheet-like configurations, and which has a microstructure of a three-dimensional continuous network of convoluted randomly disposed fibrils and bundles of fibrils. The spongy mass may also have a microstructure of predominantly randomly disposed platelets interconnecting or interpenetrating one another and also being randomly connected by randomly disposed fibrils, to form a three-dimensional continuous network.

To form such polymers, a mixture of liquid tetrafluoroethylene (TFE) monomer and at least one fluorinated surfactant in water is employed. The TFE is introduced to the reaction vessel in liquid form and the amount of surfactant used in the reaction is adjusted to maximize the formation of a bicontinuous microemulsion system. It is believed that a bicontinuous microemulsion is formed spontaneously. A suitable fluorinated surfactant or a mixture of fluorinated surfactants is needed with the weight ratio of the surfactants to all monomers of from (in the liquid phase) at least 1:10, and preferably from 1:4 or 1:2 or higher in surfactant concentration. There is no criticality in an upper limit, but generally one usually does not go higher than 5:1. The amounts of the surfactants employed are from about 0.5 to about 50 weight percent, preferably from about 1 to about 20 percent; the amounts of total monomers (in the liquid phase) are from about 0.5 to about 50 weight percent; preferably from about 1 to about 30 percent; with the remainder water and optionally some salts. Suitable fluorinated surfactants include a fluorinated anionic surfactant, for example a salt of a fluorinated carboxylic acid or a sulfonic acid, a sulfate, a cationic surfactant for example a fluorinated quartenary ammonium salt; or a fluorinated nonionic surfactant. The mixture is formed at a temperature below the critical temperature (Tc) of TFE for example approximately 33.3 °C for TFE, and above the freezing temperature of the surfactant containing aqueous solution. Pressure should be below the critical pressure of TFE (i.e. below 39 atmospheres). Mechanical stirring can be provided. Free radical polymerization can be initiated by adding water-soluble free radical initiators, for example, a peroxide, an alkaline or ammonium persulfate, or some water soluble azo compounds or a salt of permanaganate. The free radical initiators can also be used in association with a reducing agent such as ferrous salt, silver nitrate, sodium bisulfite, and the like. It is also possible to initiate the polymerization by photochemical reactions. The possible photoradiation sources include ultraviolet (UV) light, electron beam, or gamma radiation. The polymerization temperature is below the critical temperature of polytetrafluoroethylene which is about 33.3°C. A lower temperature can be any temperature above the freezing point of the mixture, but practically about 5 °C. is preferred.

Comonomers that may be present in the mixture include halogenated (chlorine or fluorine) olefins of 2-18 carbon atoms, for example vinyl chloride, vinylidene chloride, chlorotrifluoroethylene, hexafluoropropylene, perfluoroalkyl vinyl ether, or the like; hydrogenated unsaturated monomers, such as ethylene, propylene, isobutylene, vinyl acetate, acrylates, or the like; crosslinking agents, such as glycidylvinylether, chloroalkyl vinyl ether, allyl-glycidylether, acrylates, methacrylates, or the like. The amount of comonomer that can be present should not be so great as to change the nature of the product that would be obtained if PTFE had been the product.

Free radical polymerization of the unsaturated monomers in such aqueous system can sometimes yield an aqueous medium containing colloidal fluorinated olefins having three-dimensional continuous network microstructure or can yield a spongy gel material.

Without intending to limit the scope of the present invention, the apparatus and method of production of the present invention may be better understood by referring to the following examples:

### Example 1

A 150 mm silicon wafer was spin coated with a microemulsion comprising 16% PTFE, 10% ammonium perfluorooctanoate and the balance comprised water. The average PTFE particle size was about 30 nanometers. The wafer was spun at 500 RPM, dried at 220 °C and sintered at 360 °C. Film thickness was about 0.75 microns as measured by SEM in cross-section.

### Example 2

A 150 mm silicon wafer was spin coated with a microemulsion comprising 16% PTFE, 10% ammonium perfluorooctanoate, and the balance comprised water. The average PTFE particle size was about 30 nanometers. The wafer was spun at 1000 RPM, dried at 220 °C and sintered at 360 °C. Film thickness ranged from about 0.38 microns to about 0.40 microns, as measured by interferometry using a refractive index of 1.38, (using a NanoSpec 210 type interferometer from the NANOMETRICS Company).

### Example 3

A 150 mm silicon wafer was spin coated with a microemulsion comprising 16% PTFE, 10% ammonium perfluorooctanoate, and the balance comprised water. The average PTFE particle size was about 30 nanometers. The wafer was spun at 2000 RPM, dried at 200 °C and sintered at 360 °C. Film thickness ranged from about 0.28 microns to about 0.30 microns, as measured by interferometry using a refractive index of 1.38.

### Example 4

A 150 mm silicon wafer was spin coated with a microemulsion comprising 16% PTFE, 10% ammonium perfluorooctanoate, and the balance comprised water. The average PTFE particle size was about 30 nanometers. The wafer was spun at 3000 RPM, dried at 200 °C and sintered at 360 °C. Film thickness ranged from about 0.21 microns to about 0.23 microns, as measured by interferometry using a refractive index of 1.38.

### Example 5

A 150 mm silicon wafer was spin coated with a microemulsion comprising 16% PTFE, 10% ammonium perfluorooctanoate, and the balance comprised water. The average PTFE particle size was about 30 nanometers. The wafer was spun at 5000 RPM, dried at 200 °C and sintered at 360 °C. The average film thickness ranged from about 0.19 microns to about 0.22 microns, as measured by interferometry using a refractive index of 1.38.

### Example 6

A 150 mm silicon wafer was spin coated with a bicontinuous microemulsion containing 10 % PTFE, 7% ammonium perfluorooctanoate, and the balance comprised water. The wafer was spun at 500 RPM, dried at 200°C, and sintered at 360°C. The resulting coating was porous by SEM observation, and had a maximum thickness of 2 microns.

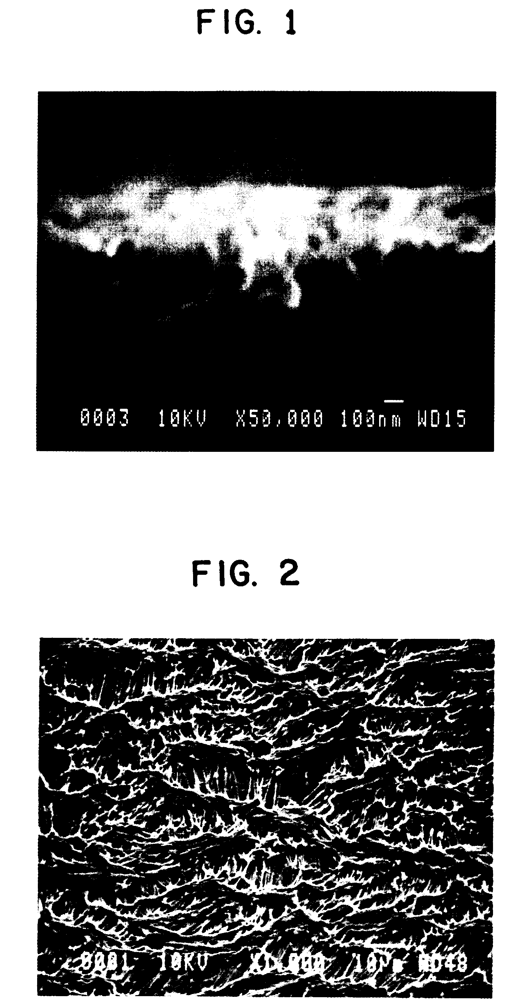

Referring to the Figures, Figure 1 is an SEM cross-section of a single crystal silicon wafer which has been coated with a PTFE microemulsion, in accordance with Example 1. The wafer was prepared by cleaving after immersing in liquid nitrogen. The bottom portion of Figure 1 is the cleaved silicon fracture surface. The middle portion of Figure 1 is the PTFE fracture surface. It is typical of low temperature, full density PTFE fracture surfaces. By scaling from the 100 nm measurement bar, the thickness is found to be approximately 0.75 microns. The top portion of Figure 1 is the as-deposited PTFE surface. It is visible because the view is slightly less than perpendicular to the fracture surface. The surface is very smooth, flat, and pinhole free.

Figure 2 is an SEM surface view of a single crystal silicon wafer which has been coated with a bicontinuous PTFE microemulsion in accordance with Example 6. The PTFE is present in a series of full density nodes which run approximately horizontally across Figure 6. These nodes are interconnected by PTFE fibrils which run approximately vertically across Figure 6. The vertical direction in Figure 6 is the same as the direction of the centrifugal force from the spinning operation. It is this force which separates the nodes, producing the fibrillation. The PTFE closely resembles conventional expanded PTFE membranes. It differs in that it was directly cast onto the surface of the wafer from the liquid microemulsion. Another method to achieve such an ILD would be to separately prepare, by a variety of extrusion and expansion processes, a PTFE membrane. This membrane would then have to be laminated onto the wafer. The teachings of the present invention eliminate many of such process steps. Also, the necessity to handle very thin membranes, which are fragile when not laminated to substrates, is eliminated by the teachings of the present invention.

Figure 3 is a graph of Deposited Film Thickness (Angstroms) v. Spin Speed (RPM) in accordance with the teachings of the present invention. It may be seen that thickness decreases smoothly with increasing rotational speed. This allows a variety of coating thicknesses in the range of from about 0.75 microns to about 0.2 microns to be easily deposited onto a substrate in accordance with the teachings herein.

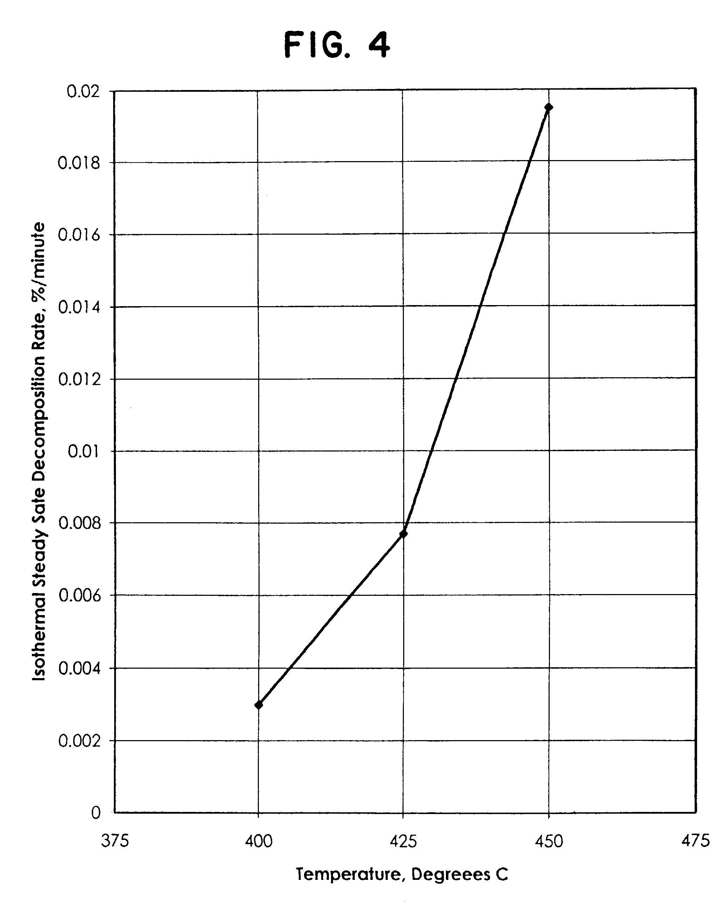

Figure 4 is a graph of Isothermal Weight Loss Rate (%/minute) v. Temperature. This graph illustrates that the low dielectric material of the present invention is particularly useful as a dielectric material for an integrated circuit structure because of the low weight loss rates experienced by this material at the high temperatures which are required in the manufacture and processing of integrated circuit structures.

## Claims

1. An improved electronic device, the improvement comprising:
a fluoropolymer or a fluorinated polymer dielectric element, said element having a weight loss of less than 0.15%/minute at 420°C, and a thickness of less than 5µm.

2. A device as claimed in claim 1 in which the dielectric element has a dielectric constant of less than 2.2.

3. A device as claimed in claim 2, wherein the dielectric element has a dielectric constant in a range from about 1.9 to about 2.2.

4. A device as claimed in any of claims 1 to 3, wherein the thickness is less than 1.5µm.

5. A device as claimed in any of claims 1 to 4, wherein the weight loss is less than 0.02%/minute at 420°C.

6. A device as claimed in claim 5, wherein the weight loss is less than 0.01%/minute at 420°C.

7. A device as claimed in any preceding claim, wherein the fluoropolymer or the fluorinated polymer is a homopolymer of tetrafluoroethylene.

8. A device as claimed in any of claims 1 to 6, wherein the fluoropolymer or the fluorinated polymer is a copolymer of tetrafluoroethylene.

9. A device as claimed in any of claims 1 to 6, wherein the fluoropolymer or the fluorinated polymer includes comonomers selected from a group consisting of hexafluoropropylene and perfluoro (alkyl vinyl ether).

10. A device as claimed in any preceding claim, wherein the fluoropolymer or the fluorinated polymer further includes antioxidants.

11. A device as claimed in any preceding claim, wherein the fluoropolymer or the fluorinated polymer further includes silicon dioxide.

12. A device as claimed in any preceding claim, wherein the fluoropolymer or the fluorinated polymer is porous.

13. An improved dielectric material for use as an insulation element in an integrated circuit structure, the improved dielectric material comprising:
a fluoropolymer material or a fluorinated polymer material having a weight loss of less than 0.15%/minute at 420°C and a thickness of less than 5µm.

14. A material as claimed in claim 13, in which the dielectric material has a dielectric constant of less then 2.2.

15. A material as claimed in claim 14, wherein the dielectric material has a dielectric constant in a range from about 1.9 to about 2.2

16. A material as claimed in any of claims 13 to 15, wherein the thickness is less than 1.5µm.

17. A material as claimed in any of claims 13 to 16, wherein the weight loss is less than 0.02%/minute at 420°C.

18. A material as claimed in claim 17, wherein the weight loss is less than 0.01%/minute at 420°C.

19. A material as claimed in any of claims 13 to 18, wherein the fluoropolymer or the fluorinated polymer is a homopolymer of tetrafluoroethylene.

20. A material as claimed in any of claims 13 to 18, wherein the fluoropolymer or the fluorinated polymer is a copolymer of tetrafluoroethylene.

21. A material as claimed in any of claims 13 to 18, wherein the fluoropolymer or the fluorinated polymer includes comonomers selected from a group consisting of hexafluoropropylene and perfluoro (alkyl vinyl ether).

22. A material as claimed in any of claims 13 to 21, wherein the fluoropolymer or the fluorinated polymer further includes antioxidants.

23. A material as claimed in any of claims 13 to 22, wherein the fluoropolymer or the fluorinated polymer further includes silicon dioxide.

24. A material as claimed in any of claims 12 to 21, wherein the fluoropolymer or the fluorinated polymer is porous.
